(19) Europäisches Patentamt

European Patent Office

Office européen des brevets

(11) Numéro de publication : **0 088 653**
**B1**

(12) **FASCICULE DE BREVET EUROPÉEN**

(45) Date de publication du fascicule du brevet :
28.08.85

(21) Numéro de dépôt : **83400320.4**

(22) Date de dépôt : **15.02.83**

(51) Int. Cl.⁴ : **H 03 H  9/36**

(54) **Ligne à retard électro-acoustique.**

(30) Priorité : **26.02.82 FR 8203263**

(43) Date de publication de la demande :
**14.09.83 Bulletin 83/37**

(45) Mention de la délivrance du brevet :
**28.08.85 Bulletin 85/35**

(84) Etats contractants désignés :
**DE GB**

(56) Documents cités :
**DE-A- 1 566 015**
**FR-A- 1 553 043**
**FR-A- 2 144 956**
**FR-A- 2 345 729**

(73) Titulaire : **THOMSON-CSF**
**173, Boulevard Haussmann**
**F-75379 Paris Cedex 08 (FR)**

(72) Inventeur : **Resneau, Jean-Claude**
**THOMSON-CSF SCPI 173, bld Haussmann**
**F-75379 Paris Cedex 08 (FR)**
Inventeur : **Da Silva, Evelyne**
**THOMSON-CSF SCPI 173, bld Haussmann**
**F-75379 Paris Cedex 08 (FR)**
Inventeur : **Puyhaubert, Jean**
**THOMSON-CSF SCPI 173, bld Haussmann**
**F-75379 Paris Cedex 08 (FR)**
Inventeur : **Lamontagne, Claude**
**THOMSON-CSF SCPI 173, bld Haussmann**
**F-75379 Paris Cedex 08 (FR)**

EP 0 088 653 B1

Jouve, 18, rue St-Denis, 75001 Paris, France

**Description**

La présente invention se rapporte d'une manière générale aux lignes à retard électroacoustiques à ondes de volume ou à ondes de surface, et concerne plus particulièrement une ligne à retard hyperfréquence opérant en transmission.

De façon générale, une ligne à retard du type transmission, par exemple à onde de volume, comporte un support de propagation acoustique constitué par un matériau retardateur monocristallin, et deux traducteurs piézoélectriques transformant une onde électromagnétique en une onde acoustique et réciproquement, fixés soit respectivement sur deux faces terminales opposées du support acoustique, soit sur une même face terminale du support.

On connaît différentes structures de ligne à retard électro-acoustique du type transmission dont les deux transducteurs sont fixés sur une même face terminale du support acoustique. On se reportera par exemple à la demande de brevet allemand n° 1 566 015 déposée le 5 décembre 1967 au nom de la Société TELEFUNKEN. Selon cette demande, la ligne à retard comporte un support acoustique délimité par une surface latérale cylindrique, une première surface terminale plane perpendiculaire à l'axe de symétrie du cylindre, ledit axe passant par le milieu de la surface plane, et une seconde surface terminale en forme de calotte sphérique assurant une focalisation de l'onde acoustique, dont le centre de courbure est situé sur l'axe de symétrie du cylindre, et dont le rayon de courbure est égal au double de la longueur du cylindre, de sorte que le plan focal de la calotte est confondu avec la surface terminale plane du support acoustique. Ainsi, l'angle formé par la surface terminale plane et l'axe de symétrie du cylindre sur lequel est centrée la calotte, est égal à 90°. De plus, les deux transducteurs piézoélectriques, respectivement d'entrée et de sortie, sont fixés symétriquement par rapport au milieu de la surface terminale plane du support, l'onde acoustique engendrée par le transducteur d'entrée étant perpendiculaire à ladite surface plane. Par une excitation du transducteur d'entrée à une fréquence hyperfréquence donnée, l'onde acoustique incidente, parallèle à l'axe du cylindre, subit une première réflexion sur la calotte focalisante, puis l'onde réfléchie vient se concentrer au milieu de la surface terminale plane où elle se réfléchit à nouveau. Cette dernière onde réfléchie subit une seconde réflexion sur la calotte focalisante, et vient ensuite se concentrer au niveau du transducteur de sortie symétrique du transducteur d'entrée, l'onde acoustique ayant ainsi parcouru deux allers et retours dans le support. Par raison de symétrie, l'onde acoustique suit le trajet inverse de celui qui vient d'être décrit.

En tenant compte par exemple de deux allers et retours de l'onde acoustique dans le support, la ligne à retard décrite ci-dessus délivre un signal retardé à un écho, et dont le retard correspond à la durée des deux allers et retours de l'onde acoustique dans le support, cette durée étant proportionnelle à la longueur du trajet de ladite onde dans le support acoustique.

Toutefois, une telle ligne à retard présente des inconvénients. En effet, pour un signal d'entrée hyperfréquence constitué par exemple par une impulsion, le signal de sortie engendré par la ligne comporte une première impulsion appelée fuite directe présentant une amplitude relativement élevée, cette fuite directe étant due au couplage entre les transducteurs d'entrée et de sortie, et une seconde impulsion représentant un écho parasite dû à la réflexion de l'onde acoustique au milieu de la surface terminale plane du support acoustique, cet écho parasite précédant une troisième impulsion constituant le premier écho. Par raison de symétrie du trajet de l'onde acoustique, le signal de sortie comporte, après le premier écho, trois autres impulsions représentant des échos parasites et précédant une impulsion constituant le second écho, et ainsi de suite.

La présente invention a pour but de remédier à ces inconvénients en proposant une ligne à retard électro-acoustique du type transmission, dont les transducteurs sont fixés sur une même face terminale du support acoustique, qui est simple à réaliser et permet d'obtenir à la fois un signal retardé à un seul écho en raison du trajet dissymétrique de l'onde acoustique, sans écho parasite, et un signal direct dû au couplage entre les deux transducteurs présentant une faible amplitude.

A cet effet, l'invention a pour objet une ligne à retard électro-acoustique opérant en transmission, comportant :

— un support de propagation d'une onde acoustique, délimité par au moins une surface latérale, une première surface terminale plane et une seconde surface terminale de révolution assurant une focalisation de l'onde acoustique ;

— un transducteur d'entrée et un transducteur de sortie transformant une onde électromagnétique en l'onde acoustique et réciproquement, les deux transducteurs étant disposés sur la surface terminale plane et étant symétriques par rapport au milieu de la surface plane, l'onde acoustique engendrée par le transducteur d'entrée se propageant selon une direction perpendiculaire à la surface terminale plane ; caractérisée en ce que l'angle formé par la surface terminale plane et l'axe de révolution de la seconde surface terminale passant par le milieu de la surface terminale plane est inférieur à 90° d'un angle complémentaire tel que l'onde acoustique engendrée par le transducteur d'entrée subisse une seule réflexion sur la surface focalisante de révolution et tel que l'onde acoustique réfléchie sur la surface de révolution vienne se concentrer au niveau du transducteur de sortie, permettant ainsi d'obtenir un signal retardé à un seul écho.

D'autres caractéristiques et avantages de l'invention apparaîtront mieux dans la description détaillée qui suit et se réfère aux dessins annexés, donnés uniquement à titre d'exemple, et dans lesquels :

la figure 1 représente schématiquement un premier mode de réalisation d'une ligne à retard selon l'invention ;

la figure 2 représente schématiquement un second mode de réalisation d'une ligne à retard selon l'invention ; et

la figure 3, a et b, représente respectivement en fonction du temps un signal d'entrée et sa réponse en sortie de la ligne à retard selon l'invention.

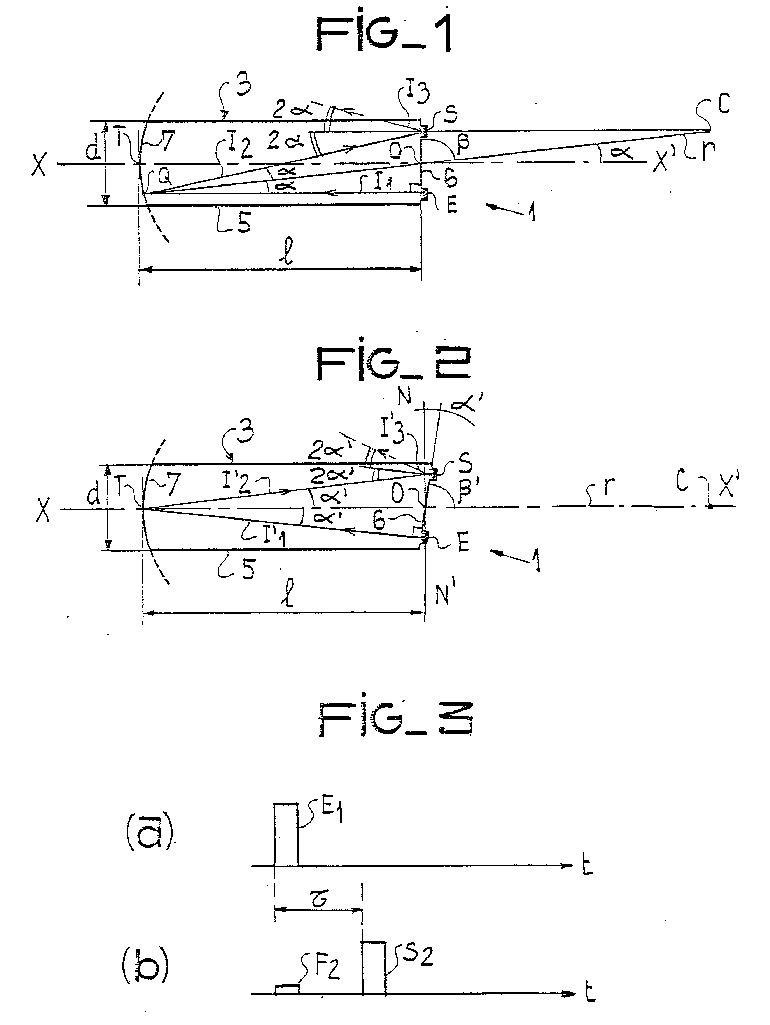

Selon un premier mode de réalisation préféré, représenté sur la figure 1, une ligne à retard 1 du type transmission, par exemple à onde de volume, conforme à l'invention, comporte un support ou milieu de propagation acoustique 3, constitué par un matériau retardateur, tel que par exemple du verre ou du corindon.

Le support 3 est délimité par une surface latérale par exemple cylindrique 5, d'axe de symétrie XX', une première surface terminale plane polie 6 perpendiculaire à l'axe XX' passant par le milieu O de ladite surface plane, et une seconde surface terminale de révolution, consituée par exemple par une calotte sphérique polie 7 décentrée par rapport à l'axe XX' et assurant une focalisation de l'onde acoustique.

Le rayon de courbure r de la calotte 7 est sensiblement égal au double de la longueur donnée l du support acoustique 3, de sorte que le plan focal de la calotte 7 est confondu avec la surface plane 6 du support. La longueur donnée l du support est déterminée comme étant la distance séparant le milieu O de la surface plane 6 du point de tangence T de la calotte sphérique 7. On a représenté en d sur la figure 1 le diamètre de la surface latérale cylindrique 5.

On notera que le support acoustique pourrait être réalisé à partir d'un parallélépipède, et que la calotte sphérique pourrait être remplacée par toute surface de révolution, telle que par exemple une portion de paraboloïde ou d'ellipsoïde, sans sortir du cadre de l'invention.

Comme il apparaît sur la figure 1, la ligne à retard 1 comporte également deux transducteurs piézoélectriques, un d'entrée E et un de sortie S, fixés sur la surface terminale plane 6 et symétriques par rapport au milieu O de ladite surface.

Le transducteur d'entrée E, relié à un circuit d'excitation hyperfréquence (non représenté), engendre une onde acoustique incidence $I_1$, qui se propage selon une direction perpendiculaire à la surface terminale plane 6 du support acoustique.

Comme on le voit bien sur la figure 1, l'angle β formé par la surface plane 6 et la droite passant par le milieu O de ladite surface plane et le centre de courbure C de la calotte sphérique 7 est inférieur à 90° d'un angle complémentaire α formé par ladite droite passant par les points O et C, et l'axe de symétrie XX' de la surface latérale cylindrique 5, cet axe consituant l'axe longitudinal du support acoustique 3. Ainsi, la calotte sphérique 7 est inclinée par rapport à l'axe longitudinal du support 3 dudit angle α constituant le complément à 90° de l'angle β.

De façon générale, pour toute surface focalisante de révolution, l'angle β est formé par la surface terminale plane et l'axe de révolution de la surface focalisante passant par le milieu de ladite surface plane, et est tel que β = 90° − α où α est choisi de telle sorte que l'onde acoustique engendrée par le transducteur d'entrée subisse une seule réflexion sur la surface focalisante, et de telle sorte que l'onde acoustique réfléchie sur la surface focalisante vienne se concentrer au niveau du transducteur de sortie.

De plus, les transducteurs d'entrée E et de sortie S représentés sur la figure 1, sont chacun disposés près d'un bord de la surface latérale cylindrique 5 du support acoustique, de sorte que lesdits transducteurs sont éloignés l'un de l'autre, permettant ainsi de réduire l'intensité du signal transmis par couplage direct entre les transducteurs.

Comme le rayon de courbure r de la calotte sphérique 7 est sensiblement égal au double de la longueur l du support acoustique, la droite passant par le transducteur de sortie S et le centre de courbure C de la calotte 7 est parallèle à l'onde acoustique incidente $I_1$ engendrée par le transducteur d'entrée E.

Ainsi, par cette construction, l'onde acoustique $I_1$ se réfléchit en un point Q de la calotte 7 situé sur la droite passant par le milieu O de la surface plane 6 et le centre de courbure C, et avec un angle de réflexion égal à l'angle complémentaire α. L'onde acoustique réfléchie $I_2$ vient ensuite se concentrer au niveau du transducteur de sortie S, puis se réfléchit sur la surface plane 6 avec un angle de réflexion égal $2\alpha$. Dès lors, l'onde acoustique $I_3$ réfléchie sur la surface plane 6 vient se réfléchir sur la surface latérale cylindrique 5 du support 3. On obtient ainsi, en sortie du transducteur S, un signal retardé à un seul écho.

Pour absorber l'onde acoustique $I_3$ se réfléchissant sur la surface latérale cylindrique 5, la ligne à retard comporte de plus des moyens d'absorption (non représentés) constitués par exemple par une couche de vernis déposée sur ladite surface latérale, de sorte que le signal retardé à un seul écho ainsi obtenu est dépourvu de tout écho parasite.

Le diagramme 3a représente en fonction du temps t un signal d'entrée hyperfréquence, constitué par exemple par une impulsion $E_1$ de niveau donné.

Le diagramme 3b représente la réponse à ce signal impulsionnel $E_1$, obtenue en sortie de la ligne à retard de la figure 1.

Ce signal de sortie comporte une impulsion $F_2$, de faible amplitude, représentant le couplage direct entre les deux transducteurs, et une impulsion $S_2$ représentant le signal retardé à un seul écho et précédé d'aucun écho parasite, le retard τ du signal $S_2$ étant proportionnel à la longueur du trajet de l'onde acoustique dans le support de propagation.

Selon un second mode de réalisation représenté sur la figure 2, et dans laquelle les éléments identiques à ceux de la figure 1 sont désignés par le même repère, la calotte sphérique 7 est centrée en C sur l'axe longitudinal XX' du support acoustique 3, ledit axe passant par le milieu O de la surface plane 6 et le rayon de courbure r de la calotte étant sensiblement égal au double de la longueur l du support.

De plus, la surface terminale plane 6 est inclinée par rapport à la normale NN' à l'axe longitudinal XX" du support 3 d'un angle $\alpha'$ déterminé de telle sorte que l'onde acoustique incidente $I_1'$, perpendiculaire à la surface plane 6 et engendrée par le transducteur d'entrée E, subisse une seule réflexion sur la calotte focalisante 7, et de telle sorte que l'onde réfléchie sur ladite calotte vienne se concentrer au niveau du transducteur de sortie S. Ainsi, l'angle $\alpha'$ constitue le complément à 90° de l'angle $\beta'$ formé par la surface plane 6 et l'axe XX' du support 3 sur lequel est centrée la calotte 7, soit $\beta' = 90° - \alpha'$.

De plus, chaque transducteur E et S est fixé sur la surface plane 6 du support, et se trouve éloigné du milieu O de ladite surface plane, permettant ainsi de diminuer le couplage direct entre les deux transducteurs.

Par cette construction, l'onde acoustique $I_1'$ subit une réflexion au point de tangence T de la calotte focalisante 7 situé sur l'axe longitudinal XX' du support, l'angle de réflexion étant égal à l'angle complémentaire $\alpha'$. L'onde acoustique ainsi réfléchi $I_2'$ vient ensuite se concentrer au niveau du transducteur de sortie S, et se réfléchit sur la surface plane 6 avec un angle de réflexion égal à $2\alpha'$.

Après réflexion sur la surface plane 6, l'onde acoustique $I_3'$ vient se réfléchir sur la surface latérale cylindrique 5 où elle est absorbée par exemple au moyen d'un revêtement acoustique (non représenté), constitué par exemple par un vernis déposé sur ladite surface latérale 5, permettant ainsi d'obtenir un signal retardé à un seul écho, sans écho parasite.

Pour un signal d'entrée du type impulsionnel tel que représenté en $E_1$ sur le diagramme 3a, le signal en sortie de la ligne à retard de la figure 2 comporte le signal direct $F_2$ (diagramme 3b) de faible amplitude, suivi directement, c'est-à-dire sans écho parasite, du signal retardé à un seul écho $S_2$.

A titre illustratif, la Demanderesse a réalisé deux lignes à retard du type transmission suivant respectivement les deux modes de réalisation représentés sur les figures 1 et 2, en utilisant pour chacune d'elles un support acoustique cylindrique en verre, de longueur l = 65 mm, de diamètre d = 20 mm, dont la surface focalisante est une calotte sphérique de rayon de courbure r = 130 mm, et dont la surface plane comporte deux transducteurs piézoélectriques distants l'un de l'autre d'une longueur égale à 15 mm. Les angles $\alpha$ (figure 1) et $\alpha'$ (figure 2) sont égaux et sont de l'ordre de 7°. Pour chacune de ces deux lignes, le retard mesuré est égal à 50μs pour une fréquence de fonctionnement de l'ordre de 40 MHz. De plus, les pertes d'insertion engendrées par chaque ligne, c'est-à-dire l'atténuation du signal de sortie par rapport au signal d'entrée, sont de l'ordre de 15 dB.

Bien entendu, l'invention n'est nullement limitée aux modes de réalisation décrits et représentés et comprend tous les équivalents techniques des moyens décrits ainsi que leurs combinaisons si celles-ci sont effectuées suivant l'esprit de l'invention et mises en œuvre dans le cadre des revendications qui suivent.

## Revendications

1. Ligne à retard électro-acoustique opérant en transmission, comportant :
— un support (3) de propagation d'une onde acoustique, délimité par au moins une surface latérale (5), une première surface terminale plane (6) et une seconde surface terminale de révolution (7) assurant une focalisation de l'onde acoustique ;
— un transducteur d'entrée (E) et un transducteur de sortie (S) transformant une onde électromagnétique en l'onde acoustique et réciproquement, les deux transducteurs étant disposés sur la surface terminale plane (6) et étant symétriques par rapport au milieu (O) de la surface plane, l'onde acoustique engendrée par le transducteur d'entrée se propageant selon une direction perpendiculaire à la surface terminale plane (6) ; caractérisée en ce que l'angle ($\beta$ ; $\beta'$) formé par la surface terminale plane et l'axe de révolution de la seconde surface terminale (7) passant par le milieu (O) de la surface terminale plane est inférieur à 90° d'un angle complémentaire ($\alpha$ ; $\alpha'$) tel que l'onde acoustique engendrée par le transducteur d'entrée subisse une seule réflexion sur la surface focalisante de révolution (7) et tel que l'onde acoustique réfléchie sur la surface de révolution vienne se concentrer au niveau du transducteur de sortie (S), permettant ainsi d'obtenir un signal retardé à un seul écho.

2. Ligne à retard selon la revendication 1, caractérisée en ce que les transducteurs d'entrée (E) et de sortie (S) sont chacun disposés au voisinage d'un bord de la surface latérale (5) du support acoustique, chaque transducteur étant ainsi éloigné du milieu (O) de la surface terminale plane (6), de sorte que l'angle complémentaire précité ($\alpha'$ ; $\alpha$) prend une valeur telle que l'onde acoustique, après réflexion sur la surface terminale plane au niveau du transducteur de sortie, vienne se réfléchir sur la surface latérale (5) du support acoustique.

3. Ligne à retard selon l'une des revendications 1 et 2, caractérisée en ce qu'elle comporte de plus des moyens pour absorber l'onde acoustique se réfléchissant sur la surface terminale plane (6) au niveau du transducteur de sortie (S), ces moyens d'absorption étant disposés sur la surface latérale (5) su support acoustique, de sorte que le signal retardé à un seul écho est dépourvu d'écho parasite.

4. Ligne à retard selon l'une des revendications 1 à 3, caractérisée en ce que la surface terminale plane (6) est perpendiculaire à l'axe longitudinal (XX') du support acoustique (3) passant par le milieu (O) de la surface terminale plane, en ce que la surface terminale de révolution (7) et son axe de révolution sont constitués respectivement par une calotte sphérique et la droite passant par le milieu (O) de la surface terminale plane et le centre de coubure (C) de la calotte, l'angle complémentaire précité (α) étant ainsi formé par l'axe longitudinal du support et ladite droite, et en ce que la droite passant par le transducteur de sortie (S) et le centre de courbure (C) de la calotte est parallèle à l'onde acoustique engendrée par le transducteur d'entrée, de sorte que l'onde acoustique engendrée par le transducteur d'entrée est réfléchie en un point (Q) de la calotte situé sur la droite passant par le milieu de la surface terminale plane et le centre de courbure, l'angle de réflexion étant ledit angle complémentaire (α).

5. Ligne à retard selon la revendication 4, caractérisée en ce que la surface latérale (5) du support acoustique est de forme cylindrique dont l'axe de symétrie constitue l'axe longitudinal du support, et en ce que la surface latérale cylindrique a une longueur donnée (1) déterminée comme étant la distance séparant le milieu (O) de la surface terminale plane du point de tangence (T) de la calotte sphérique, le rayon de courbure de la calotte étant sensiblement égal au double de la longueur de la surface latérale cylindrique.

6. Ligne à retard selon l'une des revendications 1 à 3, caractérisée en ce que la surface terminale de révolution (7) et son axe de révolution sont constitués respectivement par une calotte sphérique et la droite passant par le milieu (O) de la surface terminale plane et le centre de courbure (C) de la calotte, en ce que ladite droite constitue l'axe logitudinal du support acoustique, de sorte que la calotte est centrée sur l'axe longitudinal du support, et en ce que l'angle complémentaire précité (α') est formé par la surface terminale plane (6) et la normale (NN') à l'axe longitudinal du support, de sorte que l'onde acoustique engendrée par le transducteur d'entrée est réfléchie en un point (T) de la calotte situé sur l'axe longitudinal du support, l'angle de réflexion étant ledit angle complémentaire (α').

7. Ligne à retard selon la revendication 6, caractérisée en ce que la surface latérale (5) du support acoustique est de forme cylindrique dont l'axe de symétrie constitue l'axe longitudinal du support, en ce que la surface latérale cylindrique a une longueur donnée (1) déterminée comme étant la distance séparant le milieu (O) de la surface terminale plane du point de tangence (T) de la calotte sphérique, et en ce que le rayon de courbure de la calotte est sensiblement égal au double de la longueur de la surface latérale cylindrique.

8. Ligne à retard selon l'une des revendications précédentes, caractérisée en ce que l'onde acoustique engendrée par le transducteur d'entrée (E) est une onde de volume.

9. Ligne à retard selon l'une des revendications précédentes, caractérisée en ce que la surface terminale plane (6) et la surface terminale de révolution (7) sont polies.

**Claims**

1. Electroacoustic delay line operating in the transmission mode, comprising :
— an acoustic wave propagation carrier (3) defined by at least one lateral surface (5), a first plane end surface (6) and a second revolution surface (7) ensuring the focusing of the acoustic wave ;
— an input transducer (E) and an output transducer (S) transforming an electromagnetic wave into the acoustic wave and vice versa, said two transducers being arranged on the plane terminal surface (6) and being symmetrical with respect to the center (O) of the plane surface, the acoustic wave generated by the input transducer propagating in a direction perpendicular to the plane end surface (6) ; characterized in that the angle (β ; β') formed by the plane end surface and the axis of revolution of the second end surface (7) passing througth the center (O) of the plane end surface is inferior to 90° by a complementary angle (α ; α') such that the acoustic wave generated by the input transducer is subject to a single reflection on the focusing revolution surface (7) and such that the acoustic wave reflected on the revolution surface is concentrated at the output transducer (S), thus permitting to obtain a delayed signal having a single echo.

2. Delay line according to claim 1, characterized in that the input (E) and output (S) transducers are each arranged in the neighborhood of one edge of the lateral surface (5) of the acoustic carrier, each transducer being thus remote from the center (O) of the plane end surface (6), so that the above-mentioned complementary angle (α ; α') has such a value that the acoustic wave, after reflection on the plane end surface at the output transducer, is reflected on the lateral surface (5) of the acoustic carrier.

3. Delay line according to any of claims 1 and 2, characterized in that it further comprises means for absorbing the acoustic wave which is reflected on the plane end surface (6) at the output transducer (S), these absorption means being arranged on the lateral surface (5) of the acoustic carrier, so that the delayed signal having a single echo is free from parasitic echoes.

4. Delay line according to any of claims 1 to 3, characterized in that the plane end surface (6) is perpendicular to the longitudinal axis (XX') of the acoustic carrier (3) passing through the center (O) of the plane end surface, in that the revolution end surface (7) and its axis of revolution are respectively formed by a spherical dome and the straight line passing through the center (O) of the plane end surface and the center of curvature (C) of the dome, the above-mentioned complementary angle (α) being thus formed by the longitudinal axis of the carrier and said straight line, and in that the straight line passing through the output transducer (S) and the center of curvature (C) of the dome is parallel to the acoustic wave generated by the input transducer, so that the acoustic wave generated by the input transducer is reflected at a point (Q) of the dome lying on the straight line passing through the center of the plane end surface and the center of curvature, the reflection angle being said complementary angle (α).

5. Delay line according to claim 4, characterized in that the lateral surface (5) of the acoustic carrier has a cylindrical shape the symmetry axis of which forms said longitudinal axis of the carrier, and in that the cylindrical lateral surface has a given length (I) determined as the distance separating the center (O) of the plane end surface from the tangent point (T) of the spherical dome, the radius of curvature of the dome being substantially equal to twice the length of the lateral cylindrical surface.

6. Delay line according to any of claims 1 to 3, characterized in that the revolution end surface (7) and its axis of revolution are respectively formed by a spherical dome and by the straight line passing through the center (O) of the plane end surface and the center of curvature (C) of the dome, in that said straight line forms the longitudinal axis of the acoustic carrier, so that the dome is centered on the longitudinal axis of the carrier, and in that the above-mentioned complementary angle (α') is formed by the plane end surface (6) and the normal (NN') to the longitudinal axis of the carrier, so that the acoustic wave generated by the input transducer is reflected at a point (T) of the dome lying on the longitudinal axis of the carrier, the reflection angle being said complementary angle (α').

7. Delay line according to claim 6, characterized in that the lateral surface (5) of the acoustic carrier has a cylindrical shape the symmetry axis of which forms the longitudinal axis of the carrier, in that the lateral cylindrical surface has a given length (1) determined as the distance separating the center (O) of the plane end surface from the tangent point (T) of the spherical dome, and in that the radius of curvature of the dome is substantially equal to twice the length of the lateral cylindrical surface.

8. Delay line according to any of the preceding claims, characterized in that the acoustic wave generated by the input transducer (E) is a volume wave.

9. Delay line according to any of the preceding claims, characterized in that the plane end surface (6) and the revolution end surface (7) are polished.

**Patentansprüche**

1. Elektroakustische, im Transmissionsbetrieb arbeitende Verzögerungsleitung, enthaltend :

— einen Träger (3) für die Ausbreitung einer akustischen Welle, welcher begrenzt ist durch wenigstens eine Seitenoberfläche (5), eine erste ebene Endfläche (6) und eine zweite, rotationssymmetrische Endoberfläche (7), die eine Fokussierung der akustischen Welle gewährleistet ;
— einen Eingangswandler (E) und einen Ausgangswandler (S), die eine elektromagnetische Welle in eine Schallwelle umsetzen und umgekehrt, wobei die beiden Wandler an der ebenen Endoberfläche (6) angeordnet und symmetrisch in bezug auf die Mitte (O) der ebenen Oberfläche sind, und wobei die durch den Eingangswandler erzeugte akustische Welle sich in einer Richtung senkrecht zu der ebenen Endoberfläche (6) ausbreitet ; dadurch gekennzeichnet, daß der Winkel ( β ; β'), der durch die ebene Endoberfläche und die durch die Mitte (O) der ebenen Endoberfläche verlaufende Umdrehungsachse der zweiten Endoberfläche (7) gebildet ist, um einen solchen Komplementärwinkel (α ; α') kleiner als 90° ist, daß die durch den Eingangswandler erzeugte akustische Welle eine einzige Reflexion an der fokussierenden rotationssymmetrischen Fläche (7) erfährt, und dergestalts ist, daß die auf der rotationssymmetrichen Oberfläche reflektierte akustische Welle am Ausgangswandler (S) konzentriert wird, wodurch es ermöglicht wird, ein verzögertes Signal mit einem einzigen Echo eu erhalten.

2. Verzögerungsleitung nach Anspruch 1, dadurch gekennzeichnet, daß der Eingangswandler (E) und der Ausgangswandler (S) jeweils in der Nähe eines Randes der Seitenoberfläche (5) des akustischen Trägers angeordnet sind, wobei jeder Wandler auf diese Weise von der Mitte (O) der ebenen Endoberfläche (6) entfernt ist, so daß der genannte Komplementärwinkel (α ; α') einen solchen Wert annimmt, daß die akustische Welle nach Reflexion an der ebenen Endoberfläche im Bereich des Ausgangswandlers an der Seitenoberfläche (5) des akustischen Trägers reflektiert wird.

3. Verzögerungsleitung nach einem der Ansprüche 1 und 2, dadurch gekennzeichnet, daß sie ferner Mittel umfaßt, um die akustische Welle zu absorbieren, welche an der ebenen Endoberfläche (6) im Bereich des Ausgangswandlers (S) reflektiert wird, wobei diese Absorptionsmittel auf der Seitenoberfläche (5) des akustischen Trägers angeordnet sind, so daß das verzögerte Signal nur ein einziges Echo aufweist und von störenden Echos befreit ist.

4. Verzögerungsleitung nach einem der Ansprüche 1 bis 3, dadurch gekennzeichnet, daß die ebene Endoberfläche (6) senkrecht zur Längsachse (XX') des akustischen Trägers (3) ist, welche durch die Mitte (O) der ebenen Endoberfläche geht, daß die rotationssymmetrische Endoberfläche (7) und ihre Umdrehungsachse durch eine Kugelschale bzw. die Gerade gebildet sind, welche durch die Mitte (O) der ebenen Endoberfläche und das Krümmungszentrum (C) der Schale verläuft, wobei der genannte Komple-

mentärwinkel (α) durch die Längsachse des Trägers und die genannte Gerade gebildet ist, und daß die durch den Ausgangswandler (S) und das Krümmungszentrum (C) der Schale verlaufende Gerade parallel zu der akustischen Welle ist, die durch den Eingangswandler erzeugt wird, so daß die durch den Eingangswandler erzeugte akustische Welle an einem Punkte (Q) der Schale reflektiert wird, der auf der Geraden liegt, welche durch die Mitte der ebenen Endoberfläche und das Krümmungszentrum verläuft, wobei der Reflexionswinkel der genannte Komplementärwinkel (α) ist.

5. Verzögerungsleitung nach Anspruch 4, dadurch gekennzeichnet, daß die seitliche Oberfläche (5) des akustischen Trägers eine Zylinderform aufweist, deren Symmetrieachse die Längsachse des Trägers bildet, und daß die zylindrische Seitenoberfläche eine gegebene Länge (I) aufweist, die als Abstand zwischen der Mitte (O) der ebenen Endoberfläche und dem Berührungspunkt (T) der Kugelschale bestimmt ist, wobei der Krümmungsradius der Schale im wesentlichen gleich der zweifachen Länge der zylindrischen Seitenoberfläche ist.

6. Verzögerungsleitung nach einem der Ansprüche 1 bis 3, dadurch gekennzeichnet, daß die rotationssymmetrische Endoberfläche (7) und ihre Umdrehungsachse durch eine Kugelschale bzw. durch die Gerade gebildet sind, welche durch die Mitte (O) der ebenen Endoberfläche und das Krümmungszentrum (C) der Scale verläuft, daß die genannte Gerade die Längsachse des akustischen Trägers bildet, so daß die Schale auf der Längsachse des Trägers zentriert ist, und daß der genannte Komplementärwinkel (α') durch die ebene Endoberfläche (6) und die Senkrechte (NN') zur Längsachse des Trägers gebildet ist, so daß die durch den Eingangswandler erzeugte akustische Welle in einem Punkte (T) der Schale reflektiert wird, welcher auf der Längsachse des Trägers liegt, wobei der Reflexionswinkel der genannte Komplementärwinkel (α') ist.

7. Verzögerungsleitung nach Anspruch 6, dadurch gekennzeichnet, daß die Seitenoberfläche (5) des akustischen Trägers eine Zylinderform aufweist, deren Symmetrieachse die Längsachse des Trägers bildet, daß die zylindrische Seitenoberfläche eine gegebene Länge (1) aufweist, die als Abstand zwischen der Mitte (O) der ebenen Endoberfläche und dem Berührungspunkt (T) der Kugelschale bestimmt ist, und daß der Krümmungsradius der Schale im wesentlichen gleich der zweifachen Länge der zylindrischen Seitenoberfläche ist.

8. Verzögerungsleitung nach einem der vorstehenden Ansprüche, dadurch gekennzeichnet, daß die durch den Eingangswandler (E) erzeugte akustische Welle eine Volumenwelle ist.

9. Verzögerungsleitung nach einem der vorstehenden Ansprüche, dadurch gekennzeichnet, daß die ebene Endoberfläche und die rotationssymmetrische Endoberfläche (7) poliert sind.

0 088 653

# FIG_1

# FIG_2

# FIG_3